# EUROPEAN PATENT SPECIFICATION

(11) **EP 3 109 628 B1**
(45) Date of publication and mention of the grant of the patent: **21.07.2021**
(21) Application number: 15173192.4
(22) Date of filing: 22.06.2015
(51) Int. Cl.: G01N 27/414, H01L 29/423, H01L 29/772, H01L 29/40, H01L 29/06, B82Y 10/00, B82Y 15/00, H01L 29/16, H01L 29/778, H01L 29/786, H01L 31/028, H01L 31/10

(54) **AN APPARATUS COMPRISING A NANOMEMBRANE, AND ASSOCIATED METHODS**
VORRICHTUNG MIT EINER NANOMEMBRAN UND ZUGEHÖRIGE VERFAHREN
APPAREIL COMPRENANT UNE NANOMEMBRANE ET PROCÉDÉS ASSOCIÉS

(43) Date of publication of application: 28.12.2016
(73) Proprietor: Nokia Technologies Oy, 02610 Espoo (FI)
(72) Inventor: Haque, MD Samiul, Cambridge, CB4 1GN (GB); Borini, Stefano, Cambridge, CB3 0FA (GB)
(74) Representative: Sayer, Robert David

(56) References cited:
- WO-A1-2011/110734
- WO-A2-2009/018371
- US-A1- 2014 209 977
- Jovan Matovic ET AL: "Nanomembrane: A New MEMS/NEMS Building Block" In: "Micro Electronic and Mechanical Systems", 1 December 2009 (2009-12-01), Intech, Rijeka, Croatia, XP055079727, ISBN: 978-9-53-307027-8 pages 572-595, * Section 2: "Terminology and classification", Section 5: "Inorganic nanomembranes", Section 6:"Organic nanomembranes: macromolecules/ macromolecular composites" *
- REMKO VAN DEN HURK ET AL: "A Review of Membrane-Based Biosensors for Pathogen Detection", SENSORS, vol. 15, no. 6, 1 January 2015 (2015-01-01), pages 14045-14078, XP055235482, DOI: 10.3390/s150614045
- ANDREY TURCHANIN ET AL: "Carbon nanomembranes from self-assembled monolayers: Functional surfaces without bulk", PROGRESS IN SURFACE SCIENCE, vol. 87, no. 5, 17 May 2012 (2012-05-17), pages 108-162, XP028449303, ISSN: 0079-6816, DOI: 10.1016/J.PROGSURF.2012.05.001 [retrieved on 2012-05-17]
- WEIDONG ZHOU ET AL: "Semiconductor nanomembranes for integrated and flexible photonics", INFORMATION PHOTONICS (IP), 2011 ICO INTERNATIONAL CONFERENCE ON, IEEE, 18 May 2011 (2011-05-18), pages 1-2, XP031892970, DOI: 10.1109/ICO-IP.2011.5953817 ISBN: 978-1-61284-315-5
- KAN ZHANG ET AL: "Topical Review;Fast flexible electronics using transferrable silicon nanomembranes;Fast flexible electronics using transferrable silicon nanomembranes", JOURNAL OF PHYSICS D: APPLIED PHYSICS, INSTITUTE OF PHYSICS PUBLISHING LTD, GB, vol. 45, no. 14, 23 March 2012 (2012-03-23), page 143001, XP020220679, ISSN: 0022-3727, DOI: 10.1088/0022-3727/45/14/143001
- Daniel Rhinow ET AL: "Ultrathin conductive carbon nanomembranes as support films for structural analysis of biological specimens", PHYSICAL CHEMISTRY CHEMICAL PHYSICS, vol. 12, no. 17, 1 January 2010 (2010-01-01), pages 4345-4350, XP055686354, ISSN: 1463-9076, DOI: 10.1039/B920713A

## Description

### Technical Field

The present disclosure relates particularly to nanomembranes, associated methods and apparatus, and specifically concerns an apparatus comprising a nanomembrane which is positioned between a channel member and supporting substrate to facilitate the flow of electrical current through the channel member by inhibiting interactions between the channel member and supporting substrate. Certain disclosed example aspects/embodiments relate to field-effect transistors, smart windows and portable electronic devices, in particular, so-called hand-portable electronic devices which may be hand-held in use (although they may be placed in a cradle in use). Such hand-portable electronic devices include so-called Personal Digital Assistants (PDAs) and tablet PCs.

The portable electronic devices/apparatus according to one or more disclosed example aspects/embodiments may provide one or more audio/text/video communication functions (e.g. tele-communication, video-communication, and/or text transmission, Short Message Service (SMS)/ Multimedia Message Service (MMS)/emailing functions, interactive/non-interactive viewing functions (e.g. web-browsing, navigation, TV/program viewing functions), music recording/playing functions (e.g. MP3 or other format and/or (FM/AM) radio broadcast recording/playing), downloading/sending of data functions, image capture function (e.g. using a (e.g. in-built) digital camera), and gaming functions.

### Background

Research is currently being done to develop new electronic devices with improved physical and electrical properties.

J. Matovic et al, Micro Electronic and Mechanical Systems, 572 (2009) provides a review of nanomembranes as a new MEMS/NEMS building block.

WO2009/018371A2 describes nanomembrane structures which include a multilayer film comprising a single-crystalline layer of semiconductor material disposed between two other single-crystalline layers of semiconductor material. A plurality of holes extending through the nanomembrane are at least partially, and possibly entirely, filled with a filler material which is also a semiconductor, but which differs from the nanomembrane semiconductor materials in composition, crystal orientation, or both.

R. van den Hurk et al, Sensors, 15, No. 6, 14045 (2015) provides a review of membrane-based biosensors for pathogen detection. This review focuses on membrane materials, their associated biosensing applications, chemical linking procedures, and transduction mechanisms. The sensitivity of membrane biosensors is discussed, and the state of the field is evaluated and summarized.

A. Turchanin et al, Prog. Surf. Sci., 87, No. 5, 108 (2012) provides a review of carbon nanomembranes in which the fabrication, characterization and applications of 1 nm thick, mechanically stable carbon nanomembranes (CNMs) are described.

W. Zhou et al, Opt. Quant. Electron., 44, No. 12, 605 (2012) describes nanophotonic devices based on stacked semiconductor nanomembranes (NMs) on Si, glass and flexible PET substrates. Photonic crystal Fano resonance-based surface-normal optical filters and broadband reflectors have been demonstrated with unique angle and polarization properties. Flexible photodetectors and solar cells have also been developed based on the NM stacking processes. Such NM stacking process can lead to a paradigm shift on silicon photonic integration and hybrid organic/inorganic flexible photonics.

K. Zhang et al, J. Phys. D: Appl. Phys., 45, 143001 (2012) provides a review covering the aspects of material preparation, device fabrication and process integration for flexible electronics operating in high-frequency domain based on transferrable monocrystalline silicon (Si) nanomembranes (NM).

### Summary

The present invention comprises an apparatus, method and computer program as defined in the claims.

According to a first aspect, there is provided an apparatus comprising a channel member, first and second electrodes configured to enable a flow of electrical current from the first electrode through the channel member to the second electrode, and a supporting substrate configured to support the channel member and the first and second electrodes, wherein the channel member is separated from the supporting substrate by a nanomembrane, the nanomembrane comprising an electrically insulating carbon nanomembrane configured to facilitate the flow of electrical current through the channel member by inhibiting leakage of the electrical current from the channel member to the supporting substrate.

The nanomembrane may have a predefined thickness to provide a spacing between the channel member and supporting substrate which is sufficient to reduce electromagnetic interactions therebetween to facilitate the flow of electrical current through the channel member.

The nanomembrane may be one or more of sufficiently thick and deformable to reduce undulation, and an associated reduction in charge carrier mobility, at the channel member caused by roughness at the surface of the supporting substrate to facilitate the flow of electrical current through the channel member.

The nanomembrane may comprise a conductive material configured to shield the channel member from electric fields generated by charged species on the supporting substrate to facilitate the flow of electrical current through the channel member.

The nanomembrane may comprise a conductive material configured to shield the channel member from electromagnetic fields generated by electrical signals travelling through electrical interconnections on the supporting substrate to facilitate the flow of electrical current through the channel member.

The nanomembrane may comprise one or more dopants configured to cause a variation in the electrical current through the channel member.

The one or more dopants may be configured to form at least one of a p-type region, an n-type region, a pn-junction, a pnp-junction and an npn-junction in the channel member.

The apparatus may comprise a layer of conductive material between the nanomembrane and supporting substrate, and the nanomembrane may comprises a dielectric material configured to act as a dielectric spacer between the channel member and layer of conductive material such that a voltage applied to the layer of conductive material can be used to vary the electrical current through the channel member.

The apparatus may comprise a nanomembrane (e.g. an additional or alternative nanomembrane to the nanomembrane separating the channel member and the supporting substrate), this nanomembrane comprising a dielectric material configured to act as a dielectric spacer between the channel member and a respective layer of conductive material such that a voltage applied to the respective layer of conductive material can be used to vary the electrical current through the channel member. This nanomembrane can be considered to act as a dielectric layer where a top gate electrode can be used for FET devices.

The apparatus may comprise a third electrode separated from the channel member by a further nanomembrane, the further nanomembrane comprising a dielectric material configured to act as a dielectric spacer between the third electrode and channel member such that a voltage applied to the third electrode can be used to vary the electrical current through the channel member.

The apparatus may comprise a further nanomembrane on the side of the channel member opposite the supporting substrate, the further nanomembrane comprising a receptor species configured to bind specifically to a charged species from the surrounding environment, binding of the receptor species to the charged species positioning the charged species in sufficient proximity to the channel member to cause a variation in the electrical current therethrough.

The apparatus may comprise a further nanomembrane on the side of the channel member opposite the supporting substrate, the further nanomembrane comprising one or more pores configured to allow a specific analyte species from the surrounding environment to pass therethrough to interact with the channel member, interaction of the analyte species with the channel member causing a variation in the electrical current through the channel member.

The apparatus may comprise a further nanomembrane on the side of the channel member opposite the supporting substrate, the further nanomembrane configured to protect the underlying channel member and electrodes from the surrounding environment.

At least one of the nanomembrane, further nanomembrane, channel member, electrodes, layer of conductive material and supporting substrate may be configured to be one or more of reversibly deformable, reversibly flexible, reversibly stretchable and reversibly compressible.

At least one of the nanomembrane and further nanomembrane may have one or more of up to 10 nanomembrane layers, a thickness of up to 10nm and lateral dimensions of up to 10cm.

Each nanomembrane layer may comprise one of the following types of nanomembrane: organic, inorganic, metallic, metal-composite, glass, ceramic, dielectric, carbon, silicon, silicon dioxide, gold, silver, copper, platinum, palladium, aluminium, nickel, chromium, titanium, tungsten, lead and tin.

The channel member may comprise one or more of a metal, a semiconductor, graphene, silicon, germanium, gallium arsenide, silicon carbide, gold, silver and copper.

The supporting substrate may comprise one or more of polyimide, polyester, polyurethane and polydimethylsiloxane.

The apparatus may be one or more of an electronic device, a portable electronic device, a portable telecommunications device, a mobile phone, a personal digital assistant, a tablet, a phablet, a desktop computer, a laptop computer, a server, a smartphone, a smartwatch, smart eyewear, a circuit board, a transmission line, a sensor, a field-effect transistor, a photodetector, a phototransistor, a photodiode, a photovoltaic cell and a module for one or more of the same.

According to a further aspect, there is provided a method of making an apparatus, the method comprising the steps of claim 13.

Forming the nanomembrane on top of the supporting substrate may comprise:
depositing aromatic molecules onto the supporting substrate;
allowing the aromatic molecules to form a self-assembled monolayer; and
exposing the self-assembled monolayer to a beam of electrons to induce cross-linking of the aromatic molecules. The inducing of cross-linking of aromatic molecules may be done using heating/localised heating.

The aromatic molecules may comprise one or more of biphenylthiols, oligophenyls, hexaphenylbenzene and polycyclic aromatic hydrocarbons.

According to a further aspect, not forming part of the invention, there is provided an apparatus comprising a channel member, first and second electrodes configured to enable a flow of electrical current from the first electrode through the channel member to the second electrode, and a supporting substrate configured to support the channel member and the first and second electrodes, wherein the channel member is separated from the supporting substrate by a nanomembrane, and wherein the apparatus further comprises a layer of conductive material between the nanomembrane and supporting substrate, the nanomembrane comprising a dielectric material configured to act as a dielectric spacer between the channel member and layer of conductive material such that a voltage applied to the layer of conductive material can be used to vary the electrical current through the channel member.

The steps of any method disclosed herein do not have to be performed in the exact order disclosed, unless explicitly stated or understood by the skilled person.

Throughout the present specification, descriptors relating to relative orientation and position, such as "top", "bottom", "upper", "lower", "above" and "below", as well as any adjective and adverb derivatives thereof, are used in the sense of the orientation of the apparatus as presented in the drawings. However, such descriptors are not intended to be in any way limiting to an intended use of the described or claimed invention.

Corresponding computer programs for implementing one or more steps of the methods disclosed herein are also within the present disclosure and are encompassed by one or more of the described example embodiments.

One or more of the computer programs may, when run on a computer, cause the computer to configure any apparatus, including a battery, circuit, controller, or device disclosed herein or perform any method disclosed herein. One or more of the computer programs may be software implementations, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software may be an assembly program.

One or more of the computer programs may be provided on a computer readable medium, which may be a physical computer readable medium such as a disc or a memory device, or may be embodied as a transient signal. Such a transient signal may be a network download, including an internet download.

The present disclosure includes one or more corresponding aspects, example embodiments or features in isolation or in various combinations whether or not specifically stated (including claimed) in that combination or in isolation. Corresponding means for performing one or more of the discussed functions are also within the present disclosure.

The above summary is intended to be merely exemplary and non-limiting.

### Brief Description of the Figures

A description is now given, by way of example only, with reference to the accompanying drawings, in which:-
Figure 1 shows a conventional field-effect transistor (cross-section);
Figure 2 shows one example of the apparatus described herein comprising a top gate field-effect transistor configuration (cross-section);
Figure 3 shows another example of the apparatus described herein comprising a bottom gate field-effect transistor configuration (cross-section);
Figure 4 shows another example of the apparatus described herein comprising a top-bottom gate field-effect transistor configuration (cross-section);
Figure 5 shows another example of the apparatus described herein configured for detecting a specific analyte species (cross-section);
Figure 6 shows another example of the apparatus described herein comprising a signal line (cross-section);
Figure 7 shows another example of the apparatus described herein comprising a pn-junction (cross-section);
Figure 8 shows another example of the apparatus described herein comprising a protective layer (cross-section);
Figures 9a-d show one example of a method of forming a nanomembrane;
Figure 10a shows a test sample for use in making electrical measurements (plan view);
Figure 10b shows the test sample of Figure 10a in cross-section;
Figure 11 shows I-V measurements for graphene with and without a carbon nanomembrane;
Figure 12 shows the how the resistance of graphene with a carbon nanomembrane varied during a bending test;
Figure 13a shows an optical micrograph of graphene with a carbon nanomembrane before the bending test;
Figure 13b shows an optical micrograph of graphene with a carbon nanomembrane after the bending test;
Figure 14 shows another example of the present apparatus;
Figure 15 shows the main steps of a method of making the present apparatus;
Figure 16 shows a computer-readable medium comprising a computer program configured to perform, control or enable the method of Figure 15.

### Description of Specific Aspects/Embodiments

One or more disclosed embodiments of the present apparatus relate to field-effect transistors (FETs). An FET is a type of transistor in which an electrical current is passed through a channel, the conductance (or conductivity) of which can be controlled by a transverse electric field.

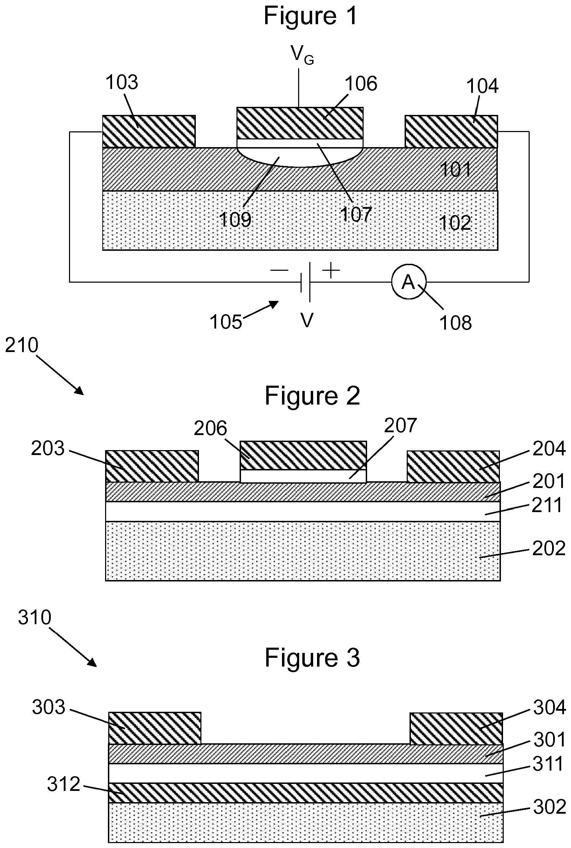

Figure 1 shows a conventional FET in cross-section. As shown in this figure, a semiconductor channel 101 (such as p-type silicon) is supported on a substrate 102 and connected to metal source 103 and drain 104 electrodes. A current enters and exits the channel via the source 103 and drain 104 electrodes, respectively, by applying a potential difference (V) 105 across the channel 101. The conductance of the channel 101 between the source 103 and drain 104 electrodes is switched on and off by a third electrode (the gate electrode 106) capacitively coupled through a thin dielectric layer 107. The conductance may be determined by measuring the current through the channel 101 (using an ammeter 108, for example) and dividing by the potential difference (V) 105. With p-type silicon (or another p-type semiconductor), application of a positive gate voltage (V_{G}) depletes the charge carriers (creating a depletion region 109 in the channel 101) and reduces the conductance, whilst applying a negative gate voltage (V_{G}) leads to an accumulation of charge carriers (creating a conductive region) and an increase in conductance.

Two factors which affect the performance of FETs are the mobility of the charge carriers through the channel, and the ratio of the conductance in the on state to the conductance in the off state (the so-called "on/off ratio"). It has been found that the mobility of the charge carriers can be adversely affected by charge carrier scattering and trapping as a result of interactions with the underlying substrate. For example, charged species adsorbed onto the surface of the substrate can give rise to electric fields at the channel, and electrical signals flowing through conductive traces on the supporting substrate (e.g. in a circuit board) can create electromagnetic fields at the channel. Furthermore, undulations in the channel caused by surface roughness at the substrate can also reduce the mobility of the charge carriers.

With regards to the on/off ratio, the electric field generated by a top gate electrode typically has less of an influence on the charge carriers near the lower surface of the channel than those near the upper surface of the channel (hence the formation of the depletion/conduction region at the upper surface only in Figure 1). This causes a reduction in the on/off ratio and can make it more difficult to control the conductance of the channel. Current leakage from the channel to the substrate can also adversely affect the device performance.

There will now be described an apparatus and associated methods that may provide a solution to one or more of these issues.

Figure 2 illustrates one example of the present apparatus 210 in cross-section. The apparatus 210 comprises a channel member 201, first 203 and second 204 electrodes configured to enable a flow of electrical current from the first electrode 203 through the channel member 201 to the second electrode 204, and a supporting substrate 202 configured to support the channel member 201 and the first 203 and second 204 electrodes. The apparatus also comprises a third electrode 206 to gate the flow of electrical current as described above. Unlike the conventional field-effect transistor structure shown in Figure 1, however, the channel member 201 is separated from the supporting substrate 202 by a nanomembrane 211 configured to facilitate the flow of electrical current through the channel member 201 by inhibiting interactions between the channel member 201 and supporting substrate 202. It will be appreciated that a flow of charge carriers between first/source electrode 203 and second/drain electrodes may comprise electron flow from the source to the drain electrode (or electron flow from the drain electrode to the source electrode depending on the naming convention used). Other charge carriers may flow from one electrode to the other in some examples (for example, holes). Thus, flow of electrical current from the first electrode through the channel member to the second electrode should be understood to be functional.

Nanomembranes can be considered to be self-supporting natural (e.g. organic) or manmade (e.g. inorganic, metallic, glass, ceramic or composite) structures with a thickness of below 100nm and a high aspect ratio which may exceed 1,000,000. In some cases, the thickness of a nanomembrane may be less than 1nm (i.e. a few atomic layers thick), which renders the structure quasi two-dimensional. Nanomembranes therefore fall simultaneously into the categories of nanoscopic objects (because of their thickness and associated low-dimensional properties) and microscopic objects (because of their comparatively large lateral dimensions).

Nanomembranes may be formed from a wide range of different materials, including, but not limited to, carbon, silicon, boron, germanium, silicon dioxide, gold, silver, copper, platinum, palladium, aluminium, nickel, chromium, titanium, tungsten, lead and tin. Furthermore, several nanomembrane layers (e.g. up to 10 layers) of the same or different materials can be stacked one on top of the other to provide additional functionality. Carbon nanomembranes may be particularly beneficial for future device applications due to their compatibility with graphene. Carbon nanomembranes are electrically insulating structures comprising a single layer of cross-linked aromatic molecules with a thickness of around 1nm (three times thicker than a single layer of graphene). Both graphene and carbon nanomembranes have a high surface to volume ratio and a combination of both materials could potentially be used to create ultrathin flexible devices in the high speed (e.g. radio frequency) and sensor fields.

The nanomembrane 211 shown in Figure facilitates the flow of electrical current in one or more different ways. For example, the nanomembrane may be configured to have a predefined thickness to provide a spacing between the channel member 201 and supporting substrate 202 which is sufficient to reduce electromagnetic interactions therebetween. Additionally or alternatively, the nanomembrane 211 may be sufficiently thick and/or deformable to reduce undulation (and the associated reduction in charge carrier mobility) at the channel member 201 caused by roughness at the surface of the supporting substrate 202. In the latter scenario, compression of a relatively thick (e.g. 50-100nm) nanomembrane 211 could be used to absorb any protrusions from the underlying substrate surface whilst leaving the upper surface of the nanomembrane 211 substantially smooth.

According to the invention, the nanomembrane 211 comprises an electrically insulating carbon nanomembrane configured to inhibit leakage of the electrical current from the channel member 201 to the supporting substrate 202, and additionally it may comprise a conductive material configured to shield the channel member 201 from electric fields generated by charged species on the supporting substrate 202. A conductive nanomembrane 211 may also be used to shield the channel member 201 from electromagnetic fields generated by electrical signals travelling through electrical interconnections (not shown) on the supporting substrate 202. Two or more of the above-mentioned functions may be provided by a single nanomembrane layer, or by several different nanomembrane layers which are stacked together to form a multilayer nanomembrane 211.

The materials used to form the nanomembrane 211, channel member 201, electrodes 203, 204, 206 and supporting substrate 202 may also be influenced by other aspects of the end product. For example, if the apparatus 210 forms part of a flexible/stretchable device, then some or all of these components may be one or more of reversibly deformable, reversibly flexible, reversibly stretchable and reversibly compressible. In this respect, the nanomembrane 211 comprises a carbon nanomembrane layer, the channel member 201 and electrodes 203, 204, 206 may comprise graphene, and the supporting substrate 202 may comprise one or more of polyimide, polyester, polyurethane and polydimethylsiloxane.

Similarly, if the apparatus 210 forms part of an electronic display or optical sensor, then some or all of these components may be substantially optically transparent. In this respect, the nanomembrane 21 comprises a carbon nanomembrane, the channel member 201 may comprise graphene, the electrodes 203, 204, 206 may comprise indium tin oxide and the supporting substrate 202 may comprise glass.

Other materials that may be used to form the channel member 201 include silicon, germanium, gallium arsenide and silicon carbide; other materials that may be used to form the electrodes 203, 204, 206 include gold, silver and copper; and other materials that may be used to form the supporting substrate 202 include silicon and polyethylene terephthalate.

Figure 3 shows another example of the present apparatus 310. In this example, instead of the third electrode 206, the apparatus 310 comprises a layer of conductive material 312 between the nanomembrane 311 and supporting substrate 302. In addition, the nanomembrane 311 comprises a dielectric material configured such that a voltage applied to the layer of conductive material 312 can be used to vary the electrical current through the channel member 301. The layer of conductive material 312 therefore serves as a bottom gate electrode and the nanomembrane 311 replaces the conventional dielectric spacer 107 (typically a ceramic). Due to the continuous structure of the nanomembrane 311 and conductive layer 312, this arrangement may provide greater control of the electrical current by allowing the transverse electric field to interact with a greater portion of the channel 301. Furthermore, the electrically insulating nature of the nanomembrane 311 helps to simplify fabrication of the apparatus 310 by removing the need to deposit a gate dielectric 107.

In other embodiments, which may (as shown in Figure 3, for example) or may not (not shown) have a nanomembrane 311, between/separating the channel member and the supporting substrate 302 configured to facilitate the flow of electrical current through the channel member by inhibiting interactions between the channel member and the supporting substrate, a dielectric nanomembrane 311' may be positioned on top (with respect to the position of the supporting substrate 302) of the channel member 301 with an appropriately positioned respective conductive material 312' (not shown). In this way, a voltage applied to the respective layer of conductive material 312' can be used to vary the electrical current through the channel member 301. This top nanomembrane can be considered to act as a dielectric layer where a top gate electrode can be used for FET devices.

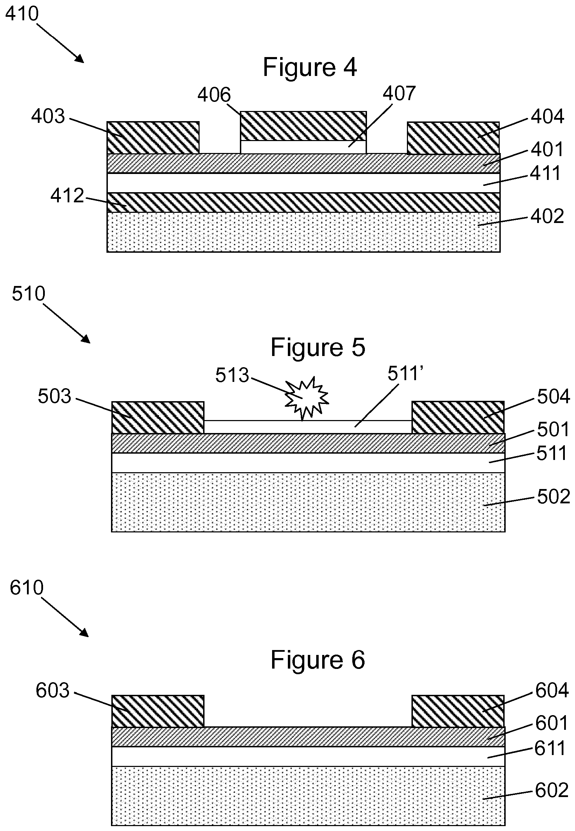

Figure 4 shows a further example of the present apparatus 410. This time, the apparatus 410 comprises the third electrode 206, 406 of Figure 2 in combination with the layer of conductive material 312, 412 of Figure 3. In this way, the flow of electrical current through the channel member 401 can be gated from both above and below the channel 401 to provide even greater control and an increase in the on/off ratio of the device 410. In some cases, the conventional dielectric 407 used to insulate the third electrode 406 from the channel member 401 may be replaced with a further dielectric nanomembrane. The use of nanomembranes 411 instead of conventional dielectric materials 407 such as ceramics (which tend to be rigid and relatively brittle) can make the apparatus 401 more resilient. This feature may therefore be useful in flexible/stretchable devices.

Figure 5 shows yet another example of the present apparatus 510. In this example, the apparatus 510 comprises a further nanomembrane 511' on top of the channel member 501 (i.e. on the side of the channel member 501 opposite the supporting substrate 502). The further nanomembrane 511' comprises a receptor species configured to bind specifically to a charged species 513 from the surrounding environment, binding of the receptor species to the charged species 513 positioning the charged species 513 in sufficient proximity to the channel member 501 to cause a variation in the electrical current therethrough. The charged species 513 therefore gates the channel member 501 instead of an electrode 106 or layer of conductive material 312. In this way, the apparatus 510 may be used as a sensor for detecting one or more of the presence and magnitude of the charged species 513 in the surrounding environment. For qualitative detection, the mere determination of a change in current (or conductivity/conductance) by a predefined amount may be sufficient to deduce the presence of the charged species 513. For quantitative detection, on the other hand, the concentration of the charged species 513 versus current (or conductivity/conductance) would typically need to be pre-calibrated.

Rather than the further nanomembrane 511' of Figure 5 comprising a receptor species for specific binding, it may comprise one or more pores configured (e.g. based on one or more of size, shape and chemistry) to allow a specific analyte species from the surrounding environment to pass therethrough to interact with the channel member 501 and cause a variation in the electrical current and therefore allowing selectivity in sensing different analytes. In this scenario, the specific analyte species may be a chemical or biological species which reacts with the channel member to cause a change in the electrical current, or it may be a charged chemical or biological species 513 which is capable of directly gating the channel member 501. The further nanomembrane 511' of this example therefore serves as an analyte filter to provide the specificity required for accurate detection. In other scenarios, the apparatus may be configured such that the analyte can directly interact with the nanomembrane and a charge transfer can occur which can modulate the electrical current through the channel member.

Figure 6 shows another example of the present apparatus 610. In this example, there is no gating of the channel member 601, and the electrical current is in the form of an electrical signal transmitted from the first electrode 603 through the channel member 601 to the second electrode 604. The channel member 601 may therefore serve as an electrical trace of a circuit board or as a signal line of a transmission line (such as a microstrip or coplanar waveguide), both of which can benefit from the above-mentioned electrical properties provided by the nanomembrane 611.

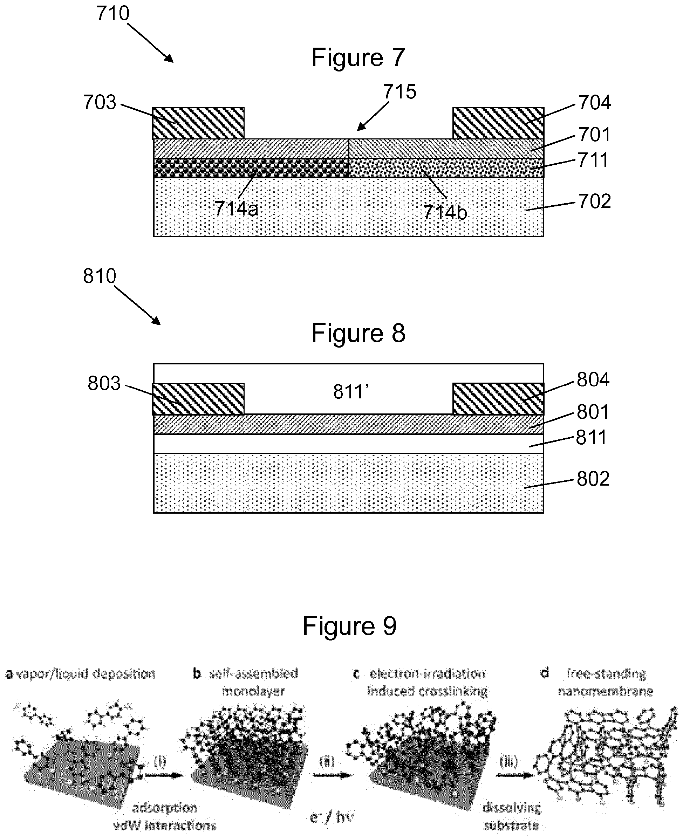

Figure 7 shows an example of the present apparatus 710 which takes advantage of the ability to functionalise nanomembranes 711 with different chemical or biological species. In this example, the nanomembrane 711 comprises one or more dopants 714a,b configured to cause a variation in the electrical current through the channel member 701. For example, the one or more dopants 714a,b may be configured to form at least one of a p-type region, an n-type region, a pn-junction 715 (as illustrated), a pnp-junction and an npn-junction in the adjacent channel member 701, thus avoiding the need to dope the channel member 701 directly in order to form such structures 715. This aspect may therefore be useful in the fabrication of semiconductor devices such as photodetectors, phototransistors, photodiodes and photovoltaic cells. Examples of suitable dopants 714a,b include boron, phosphorus, copper, nickel, silicon carbide, nitrogen, nitrogen dioxide and two-dimensional materials such as molybdenum disulphide, hexagonal boron nitride and phosphorene. These may be added to one or more of the top and bottom surfaces of the nanomembrane 711.

Figure 8 shows yet another example of the present apparatus 810. In this example, the apparatus 810 comprises a further nanomembrane 811' on top of the channel member 801 and electrodes 803, 804 (i.e. on the environment side of the channel member 801 opposite the supporting substrate 802), the further nanomembrane 811' configured to protect the underlying channel member 801 and electrodes 803, 804 from the surrounding environment. The further nanomembrane 811' therefore does not perform an active role in the operation of the device 810, but rather functions to preserve said device operation. In some examples, the further nanomembrane 811' may comprise a dielectric material configured to insulate the channel member 801 and electrodes 803, 804 from other conductive components of the apparatus 810. If the apparatus 810 is intended for use outdoors (e.g. as an environmental sensor), then the further nanomembrane 811' may additionally or alternatively comprise an inert material configured to prevent any reactions with the elements (e.g. air or water). The inert material may also be dielectric to prevent the creation of short circuits by rain water or moisture in the air.

Figures 9a-d shows one method of forming large area (e.g. lateral dimensions of up to 10cm in this case, although large scale manufacturing not limited to 10cm lateral dimensions is feasible) carbon nanomembranes with a homogeneous thickness (e.g. up to 3nm) and tailored physical and chemical properties, which is not currently possible by direct chemical synthesis. The method involves depositing aromatic molecules as a liquid or vapour onto the surface of a supporting substrate (Figure 9a) and allowing the aromatic molecules to form a self-assembled monolayer via adsorption and van der Waals interactions (Figure 9b). The self-assembled monolayer is then exposed to a beam of electrons to induce cross-linking of the aromatic molecules (Figure 9c), and the supporting substrate is dissolved (e.g. by wet etching) to leave a free-standing nanomembrane (Figure 9d). In some cases, the supporting substrate may be retained to provide additional support to the nanomembrane and other components (i.e. the substrate used during fabrication may form part of the final apparatus).

The thickness, homogeneity, presence of pores and surface chemistry of the resulting carbon nanomembrane are determined by the nature of the self-assembled monolayer, which itself depends on the constituent aromatic molecules. Examples of suitable aromatic molecules include polyaromatic molecules such as oligophenyls, hexaphenylbenzene and polycyclic aromatic hydrocarbons. Thiol-based precursors such as non-fused oligophenyl derivatives possess linear molecular backbones that provide an improved structural ordering of the self-assembled monolayer. One particular example is 1,1-biphenyl-4-thiol (which may or may not be doped with nitrogen). On the other hand, condensed polycyclic precursors like naphthalene, anthracene and pyrene mercapto derivatives are more rigid and can provide greater stability and an increased carbon density in the monolayers. Other examples of aromatic molecules include "bulky" molecules like the non-condensed hexaphenylbenzene derivative with a propellerlike structure, and extended disc-type polycyclic aromatic hydrocarbons such as hexa-peribenzocoronene derivatives.

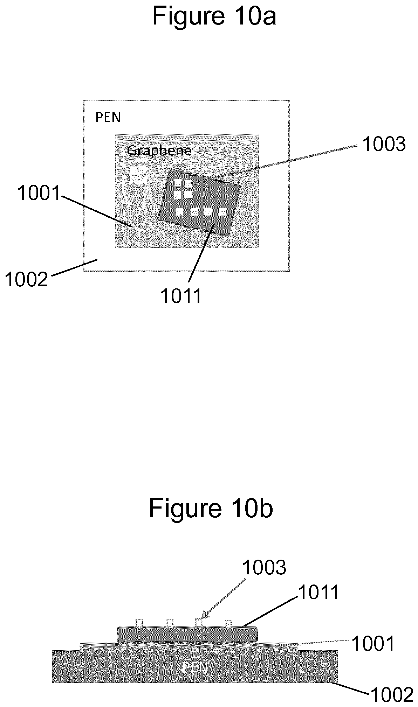

Figures 10a and 10b show (in plan view and cross-section, respectively) a test sample that was fabricated for use in testing the electrical properties of the present apparatus. The test sample comprises a carbon nanomembrane 1011 separated from a polyethylene naphthalate (PEN) substrate 1002 by a chemical vapour deposited graphene channel 1001 of length 500µm and width 1mm. The sample also comprises a number of silver electrodes 1003 on top of the carbon nanomembrane 1011 and graphene 1001 to investigate the electrical conductivity of the graphene channel 1001 through the membrane-graphene interface. A further test sample formed without the carbon nanomembrane 1011 was also fabricated for comparison.

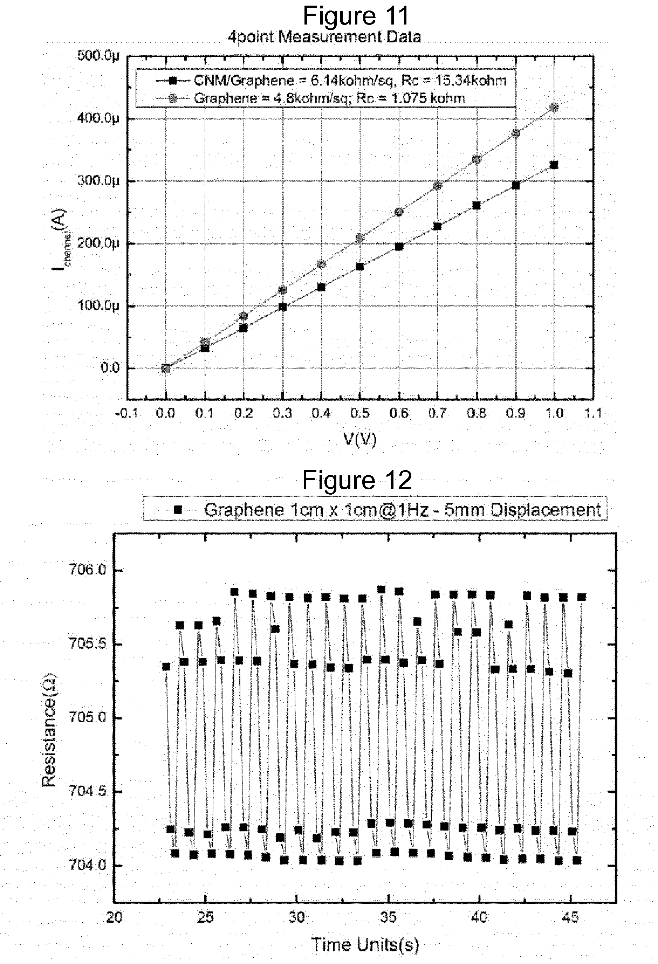

Figure 11 shows the results of 4-point I-V measurements made with and without the carbon nanomembrane. These results show a contact resistance of 1.075kΩ and a sheet resistivity of 4.8kΩ/sq for the sample without the carbon nanomembrane, and a contact resistance of 15.34kΩ and a sheet resistance of 6.14kΩ/sq for the sample with the carbon nanomembrane. These values indicate that the carbon nanomembrane itself is electrically insulating, which supports its use as a dielectric material for use in field-effect devices and the like.

The test samples were then subjected to repetitive mechanical bending to determine any changes in their electrical properties with deformation. During this experiment, the samples were flexed back and forth 1000 times at a frequency of 1Hz with a displacement of 5mm in compression mode and a bending radius of -12.5mm.

Figure 12 shows the results of the mechanical bending test for the sample with the carbon nanomembrane. It was found that the resistance increased slightly for both samples under compressive strain, with a change in resistance of around 0.3% and a gauge factor of 0.57.

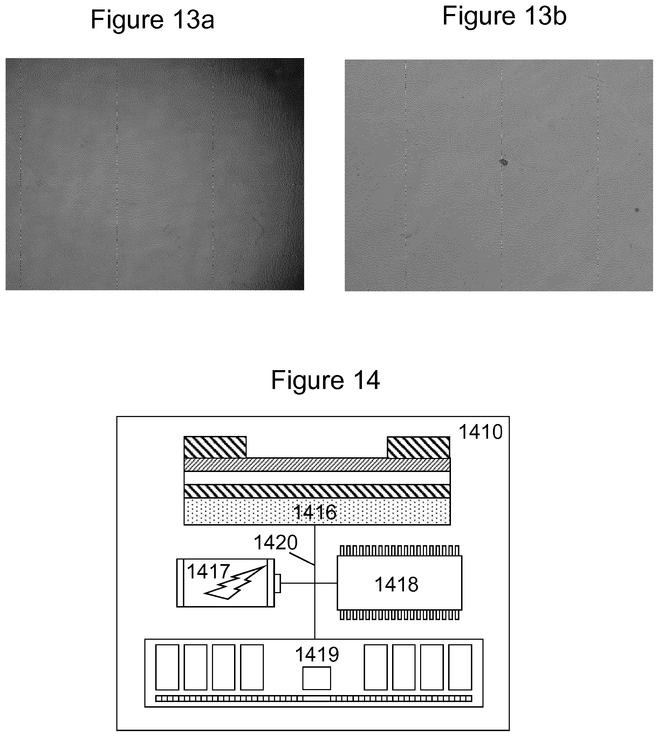

Figures 13a and 13b show optical micrographs of the sample comprising the nanomembrane taken before and after the 1000 bending cycles, respectively. The lack of cracks or major defects on the surface indicates that there was no degradation of the sample as a result of the mechanical deformation.

Figure 14 shows another example of the present apparatus 1410. The apparatus 1410 may be one or more of an electronic device, a portable electronic device, a portable telecommunications device, a mobile phone, a personal digital assistant, a tablet, a phablet, a desktop computer, a laptop computer, a server, a smartphone, a smartwatch, smart eyewear, a circuit board, a transmission line, a sensor, a field-effect transistor, a photodetector, a phototransistor, a photodiode, a photovoltaic cell and a module for one or more of the same. In the example shown, the apparatus 1410 comprises the various components described previously (denoted by reference numeral 1416), a power source 1417, a processor 1418 and a storage medium 1419, which are electrically connected to one another by a data bus 1420.

The processor 1418 is configured for general operation of the apparatus 1410 by providing signalling to, and receiving signalling from, the other components to manage their operation. The storage medium 1419 is configured to store computer code configured to perform, control or enable operation of the apparatus 1410. The storage medium 1419 may also be configured to store settings for the other components. The processor 1418 may access the storage medium 1419 to retrieve the component settings in order to manage the operation of the other components.

Under the control of the processor 1418, the power source 1417 is configured to apply a voltage between the first and second electrodes to enable a flow of electrical current from the first electrode through the channel member to the second electrode. In the case of field-effect devices, the power source 1417 (under the control of the processor 1418) may be configured to apply a gate voltage to a third electrode (and/or layer of conductive material) to cause a detectable change in the flow of electrical current. In this way, the apparatus 1410 may act as an electronic switch within the circuitry of the apparatus 1410.

The processor 1418 may be a microprocessor, including an Application Specific Integrated Circuit (ASIC). The storage medium 1419 may be a temporary storage medium such as a volatile random access memory. On the other hand, the storage medium 1419 may be a permanent storage medium 1419 such as a hard disk drive, a flash memory, or a non-volatile random access memory. The power source 1417 may comprise one or more of a primary battery, a secondary battery, a capacitor, a supercapacitor and a battery-capacitor hybrid.

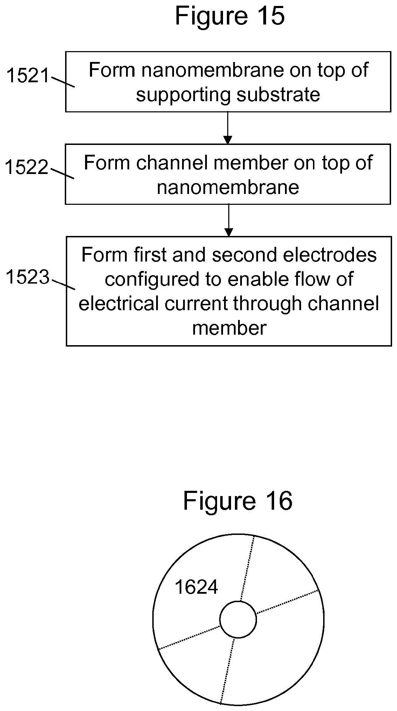

Figure 15 shows the main steps 1521-1523 of a method of making an apparatus described herein. The method generally comprises: forming a nanomembrane on top of a supporting substrate 1521; forming a channel member on top of the nanomembrane 1522; and forming first and second electrodes configured to enable a flow of electrical current from the first electrode through the channel member to the second electrode 1523.

Figure 16 illustrates schematically a computer/processor readable medium 1624 providing a computer program according to one embodiment. The computer program may comprise computer code configured to perform, control or enable one or more of the method steps 1521-1523 of Figure 15. Additionally or alternatively, the computer program may comprise computer code configured to apply a voltage between the first and second electrodes to enable a flow of electrical current from the first electrode through the channel member to the second electrode. The computer program may also comprise computer code configured to apply a gate voltage to the third electrode (and/or layer of conductive material) to cause a detectable change in the flow of electrical current.

In this example, the computer/processor readable medium 1624 is a disc such as a digital versatile disc (DVD) or a compact disc (CD). In other embodiments, the computer/processor readable medium 1624 may be any medium that has been programmed in such a way as to carry out an inventive function. The computer/processor readable medium 1624 may be a removable memory device such as a memory stick or memory card (SD, mini SD, micro SD or nano SD).

Other embodiments depicted in the figures have been provided with reference numerals that correspond to similar features of earlier described embodiments. For example, feature number 1 can also correspond to numbers 101, 201, 301 etc. These numbered features may appear in the figures but may not have been directly referred to within the description of these particular embodiments. These have still been provided in the figures to aid understanding of the further embodiments, particularly in relation to the features of similar earlier described embodiments.

It will be appreciated to the skilled reader that any mentioned apparatus/device and/or other features of particular mentioned apparatus/device may be provided by apparatus arranged such that they become configured to carry out the desired operations only when enabled, e.g. switched on, or the like. In such cases, they may not necessarily have the appropriate software loaded into the active memory in the non-enabled (e.g. switched off state) and only load the appropriate software in the enabled (e.g. on state). The apparatus may comprise hardware circuitry and/or firmware. The apparatus may comprise software loaded onto memory. Such software/computer programs may be recorded on the same memory/processor/functional units and/or on one or more memories/processors/functional units.

In some embodiments, a particular mentioned apparatus/device may be pre-programmed with the appropriate software to carry out desired operations, and wherein the appropriate software can be enabled for use by a user downloading a "key", for example, to unlock/enable the software and its associated functionality. Advantages associated with such embodiments can include a reduced requirement to download data when further functionality is required for a device, and this can be useful in examples where a device is perceived to have sufficient capacity to store such pre-programmed software for functionality that may not be enabled by a user.

It will be appreciated that any mentioned apparatus/circuitry/elements/processor may have other functions in addition to the mentioned functions, and that these functions may be performed by the same apparatus/circuitry/elements/processor. One or more disclosed aspects may encompass the electronic distribution of associated computer programs and computer programs (which may be source/transport encoded) recorded on an appropriate carrier (e.g. memory, signal).

It will be appreciated that any "computer" described herein can comprise a collection of one or more individual processors/processing elements that may or may not be located on the same circuit board, or the same region/position of a circuit board or even the same device. In some embodiments one or more of any mentioned processors may be distributed over a plurality of devices. The same or different processor/processing elements may perform one or more functions described herein.

It will be appreciated that the term "signalling" may refer to one or more signals transmitted as a series of transmitted and/or received signals. The series of signals may comprise one, two, three, four or even more individual signal components or distinct signals to make up said signalling. Some or all of these individual signals may be transmitted/received simultaneously, in sequence, and/or such that they temporally overlap one another.

With reference to any discussion of any mentioned computer and/or processor and memory (e.g. including ROM, CD-ROM etc), these may comprise a computer processor, Application Specific Integrated Circuit (ASIC), field-programmable gate array (FPGA), and/or other hardware components that have been programmed in such a way to carry out the inventive function.

## Claims

1. An apparatus (210) comprising a channel member (201), first (203) and second (204) electrodes configured to enable a flow of electrical current from the first electrode (203) through the channel member (201) to the second electrode (204), and a supporting substrate (202) configured to support the channel member (201) and the first (203) and second (204) electrodes, wherein the channel member (201) is separated from the supporting substrate (202) by a nanomembrane (211) **characterised in that**,
the nanomembrane layer comprises an electrically-insulating carbon nanomembrane layer configured to facilitate the flow of electrical current through the channel member (201) by inhibiting leakage of the electrical current from the channel member (201) to the supporting substrate (202).

2. The apparatus (210) of claim 1, wherein the nanomembrane (211) has a predefined thickness to provide a spacing between the channel member (201) and supporting substrate (202) which is sufficient to reduce electromagnetic interactions therebetween to facilitate the flow of electrical current through the channel member (201).

3. The apparatus (210) of claim 1 or 2, wherein the nanomembrane (211) is one or more of sufficiently thick and deformable to reduce undulation, and an associated reduction in charge carrier mobility, at the channel member (201) caused by roughness at the surface of the supporting substrate (202) to facilitate the flow of electrical current through the channel member (201).

4. The apparatus (210) of any preceding claim, wherein the nanomembrane (211) comprises a conductive material configured to shield the channel member (201) from electric fields generated by charged species on the supporting substrate (202) to facilitate the flow of electrical current through the channel member (201).

5. The apparatus (210) of any preceding claim, wherein the nanomembrane (211) comprises a conductive material configured to shield the channel member (201) from electromagnetic fields generated by electrical signals travelling through electrical interconnections on the supporting substrate (202) to facilitate the flow of electrical current through the channel member (201).

6. The apparatus (210) of any preceding claim, wherein the nanomembrane (211) comprises one or more dopants (714a,b) configured to cause a variation in the electrical current through the channel member (201).

7. The apparatus (210) of any preceding claim, wherein the apparatus (210) comprises a layer of conductive material (312) between the nanomembrane (211) and supporting substrate (202), and wherein the nanomembrane (211) comprises a dielectric material configured to act as a dielectric spacer between the channel member (201) and layer of conductive material (312) such that a voltage applied to the layer of conductive material (312) can be used to vary the electrical current through the channel member (201).

8. The apparatus (210) of any preceding claim, wherein the apparatus (210) comprises a third electrode (206) separated from the channel member (201) by a further nanomembrane (207), the further nanomembrane (207) comprising a dielectric material configured to act as a dielectric spacer between the third electrode (206) and channel member (201) such that a voltage applied to the third electrode (206) can be used to vary the electrical current through the channel member (201).

9. The apparatus (210) of any of the claims 1 to 6, wherein the apparatus (210) comprises a further nanomembrane (511') on the side of the channel member (201) opposite the supporting substrate (202), the further nanomembrane (511') comprising a receptor species configured to bind specifically to a charged species (513) from the surrounding environment, binding of the receptor species to the charged species (513) positioning the charged species (513) in sufficient proximity to the channel member (201) to cause a variation in the electrical current therethrough.

10. The apparatus (210) of any of the claims 1 to 8, wherein the apparatus (210) comprises a further nanomembrane (511') on the side of the channel member (201) opposite the supporting substrate (202), the further nanomembrane (511') comprising one or more pores configured to allow a specific analyte species (513) from the surrounding environment to pass therethrough to interact with the channel member (201), interaction of the analyte species (513) with the channel member (201) causing a variation in the electrical current through the channel member (201).

11. The apparatus (210) of any of the claims 1 to 8, wherein the apparatus (210) comprises a further nanomembrane (811') on the side of the channel member (201) opposite the supporting substrate (202), the further nanomembrane (811') configured to protect the channel member (201) and electrodes (203, 204) from the surrounding environment.

12. The apparatus (210) of any preceding claim, wherein at least one of the nanomembrane (211), further nanomembrane (207, 511', 811'), channel member (201), electrodes (203, 204), layer of conductive material (312) and supporting substrate (202) are configured to be one or more of reversibly deformable, reversibly flexible, reversibly stretchable and reversibly compressible.

13. A method of making an apparatus (210), the method comprising:
forming (1521) a nanomembrane (211) comprising an electrically insulating carbon nanomembrane layer on top of a supporting substrate (202);
forming (1522) a channel member (201) on top of the nanomembrane (211); and
forming (1523) first (203) and second (204) electrodes configured to enable a flow of electrical current from the first electrode (203) through the channel member (201) to the second electrode (204), wherein the nanomembrane (211) is configured to facilitate the flow of electrical current through the channel member (201) by inhibiting leakage of the electrical current from the channel member (201) to the supporting substrate (202).

14. A computer program comprising computer code configured to control the method of claim 13.

## Patentansprüche

1. Einrichtung (210) umfassend ein Kanalelement (201), eine erste (203) und eine zweite (204) Elektrode, die konfiguriert sind, um einen elektrischen Stromfluss von der ersten Elektrode (203) durch das Kanalelement (201) zu der zweiten Elektrode (204) zu ermöglichen, und ein Trägersubstrat (202), das konfiguriert ist, um das Kanalelement (201) und die erste (203) und zweite (204) Elektrode zu tragen, wobei das Kanalelement (201) durch eine Nanomembran (211) von dem Trägersubstrat (202) getrennt ist, **dadurch gekennzeichnet, dass** die Nanomembranschicht eine elektrisch-isolierende Kohlenstoff-Nanomembranschicht umfasst, die konfiguriert ist, um den elektrischen Stromfluss durch das Kanalelement (201) zu erleichtern, indem sie das Austreten des elektrischen Stroms aus dem Kanalelement (201) in das Trägersubstrat (202) verhindert.

2. Einrichtung (210) nach Anspruch 1, wobei die Nanomembran (211) eine vordefinierte Dicke aufweist, um einen Abstand zwischen dem Kanalelement (201) und dem Trägersubstrat (202) zu schaffen, der ausreicht, um elektromagnetische Wechselwirkungen dazwischen zu reduzieren, um den elektrischen Stromfluss durch das Kanalelement (201) zu erleichtern.

3. Einrichtung (210) nach Anspruch 1 oder 2, wobei die Nanomembran (211) eine oder mehrere der folgenden Eigenschaften aufweist: ausreichend dick und verformbar, um die Wellenbildung und eine damit verbundene Verringerung der Ladungsträgerbeweglichkeit an dem Kanalelement (201) zu reduzieren, die durch Rauheit an der Oberfläche des Trägersubstrats (202) verursacht wird, um den elektrischen Stromfluss durch das Kanalelement (201) zu erleichtern.

4. Einrichtung (210) nach einem der vorstehenden Ansprüche, wobei die Nanomembran (211) ein leitfähiges Material aufweist, das konfiguriert ist, um das Kanalelement (201) gegen elektrische Felder abzuschirmen, die durch geladene Spezies auf dem Trägersubstrat (202) erzeugt werden, um den elektrischen Stromfluss durch das Kanalelement (201) zu erleichtern.

5. Einrichtung (210) nach einem der vorstehenden Ansprüche, wobei die Nanomembran (211) ein leitfähiges Material aufweist, das konfiguriert ist, um das Kanalelement (201) gegen elektromagnetische Felder abzuschirmen, die durch elektrische Signale erzeugt werden, welche sich durch elektrische Verbindungen auf dem Trägersubstrat (202) ausbreiten, um den elektrischen Stromfluss durch das Kanalelement (201) zu erleichtern.

6. Einrichtung (210) nach einem der vorstehenden Ansprüche, wobei die Nanomembran (211) einen oder mehrere Dotierstoffe (714a,b) umfasst, die konfiguriert sind, um eine Veränderung des elektrischen Stroms durch das Kanalelement (201) zu bewirken.

7. Einrichtung (210) nach einem der vorstehenden Ansprüche, wobei die Einrichtung (210) eine Schicht aus leitfähigem Material (312) zwischen der Nanomembran (211) und dem Trägersubstrat (202) umfasst, und wobei die Nanomembran (211) ein dielektrisches Material umfasst, das konfiguriert ist, um als ein dielektrischer Abstandshalter zwischen dem Kanalelement (201) und der Schicht aus leitfähigem Material (312) zu wirken, so dass eine an die Schicht aus leitfähigem Material (312) angelegte Spannung verwendet werden kann, um den elektrischen Strom durch das Kanalelement (201) zu variieren.

8. Einrichtung (210) nach einem der vorstehenden Ansprüche, wobei die Einrichtung (210) eine dritte Elektrode (206) umfasst, die durch eine weitere Nanomembran (207) von dem Kanalelement (201) getrennt ist, wobei die weitere Nanomembran (207) ein dielektrisches Material umfasst, das konfiguriert ist, um als ein dielektrischer Abstandshalter zwischen der dritten Elektrode (206) und dem Kanalelement (201) zu wirken, so dass eine an die dritte Elektrode (206) angelegte Spannung verwendet werden kann, um den elektrischen Strom durch das Kanalelement (201) zu variieren.

9. Einrichtung (210) nach einem der Ansprüche 1 bis 6, wobei die Einrichtung (210) eine weitere Nanomembran (511') auf der dem Trägersubstrat (202) gegenüberliegenden Seite des Kanalelements (201) umfasst, wobei die weitere Nanomembran (511') eine Rezeptorspezies umfasst, die konfiguriert ist, um sich spezifisch an eine geladene Spezies (513) aus der Umgebung zu binden, wobei das Binden der Rezeptorspezies an die geladene Spezies (513) die geladene Spezies (513) in ausreichender Nähe zu dem Kanalelement (201) positioniert, um eine Veränderung des elektrischen Stroms durch dieses zu bewirken.

10. Einrichtung (210) nach einem der Ansprüche 1 bis 8, wobei die Einrichtung (210) eine weitere Nanomembran (511') auf der dem Trägersubstrat (202) gegenüberliegenden Seite des Kanalelements (201) umfasst, wobei die weitere Nanomembran (511') eine oder mehrere Poren umfasst, die konfiguriert sind, um einer spezifischen Analytspezies (513) aus der Umgebung zu erlauben, durch sie hindurchzutreten, um mit dem Kanalelement (201) in Wechselwirkung zu treten, wobei die Wechselwirkung der Analytspezies (513) mit dem Kanalelement (201) eine Veränderung des elektrischen Stroms durch das Kanalelement (201) bewirkt.

11. Einrichtung (210) nach einem der Ansprüche 1 bis 8, wobei die Einrichtung (210) eine weitere Nanomembran (811') auf der dem Trägersubstrat (202) gegenüberliegenden Seite des Kanalelements (201) umfasst, wobei die weitere Nanomembran (811') konfiguriert ist, um das Kanalelement (201) und die Elektroden (203, 204) vor der Umgebung zu schützen.

12. Einrichtung (210) nach einem der vorstehenden Ansprüche, wobei mindestens eines von der Nanomembran (211), der weiteren Nanomembran (207, 511', 811'), dem Kanalelement (201), den Elektroden (203, 204), der Schicht aus leitfähigem Material (312) und dem Trägersubstrat (202) konfiguriert ist, um reversibel verformbar, reversibel flexibel, reversibel dehnbar und/oder reversibel komprimierbar zu sein.

13. Verfahren zur Herstellung einer Einrichtung (210), wobei das Verfahren umfasst:
Bilden (1521) einer Nanomembran (211) mit einer elektrisch isolierenden Kohlenstoff-Nanomembranschicht auf der Oberseite eines Trägersubstrats (202);
Bilden (1522) eines Kanalelements (201) auf der Oberseite der Nanomembran (211); und
Bilden (1523) einer ersten (203) und einer zweiten (204) Elektrode, die konfiguriert sind, um einen elektrischen Stromfluss von der ersten Elektrode (203) durch das Kanalelement (201) zu der zweiten Elektrode (204) zu ermöglichen, wobei die Nanomembran (211) konfiguriert ist, um den elektrischen Stromfluss durch das Kanalelement (201) zu erleichtern, indem sie das Austreten des elektrischen Stroms aus dem Kanalelement (201) in das Trägersubstrat (202) verhindert.

14. Computerprogramm mit Computercode, der konfiguriert ist, um das Verfahren nach Anspruch 13 zu steuern.

## Revendications

1. Dispositif (210) comprenant un élément de canal (201), des première (203) et deuxième (204) électrodes configurées pour permettre une circulation de courant électrique de la première électrode (203) à la deuxième électrode (204) par l'intermédiaire de l'élément de canal (201), et un substrat de support (202) configuré pour supporter l'élément de canal (201) et les première (203) et deuxième (204) électrodes, dans lequel l'élément de canal (201) est séparé du substrat de support (202) par une nanomembrane (211), **caractérisé en ce que** la couche de nanomembrane comprend une couche de nanomembrane en carbone électriquement isolante configurée pour faciliter la circulation du courant électrique à travers l'élément de canal (201) en inhibant les fuites de courant électrique de l'élément de canal (201) au substrat de support (202).

2. Dispositif (210) selon la revendication 1, dans lequel la nanomembrane (211) a une épaisseur prédéfinie pour former un espace entre l'élément de canal (201) et le substrat de support (202) qui est suffisant pour réduire les interactions électromagnétiques entre eux pour faciliter la circulation de courant électrique à travers l'élément de canal (201) .

3. Dispositif (210) selon la revendication 1 ou 2, dans lequel la nanomembrane (211) est une ou plusieurs suffisamment épaisses ou déformables pour réduire les ondulations, et une réduction associée de la mobilité des supports de charge, au niveau de l'élément de canal (201), dues à la rugosité sur la surface du substrat de support (202) pour faciliter la circulation de courant électrique à travers l'élément de canal (201) .

4. Dispositif (210) selon l'une quelconque des revendications précédentes, dans lequel la nanomembrane (211) comprend un matériau conducteur configuré pour blinder l'élément de canal (201) vis-à-vis de champs électriques générés par des espèces chargées sur le substrat de support (202) pour faciliter la circulation de courant électrique à travers l'élément de canal (201).

5. Dispositif (210) selon l'une quelconque des revendications précédentes, dans lequel la nanomembrane (211) comprend un matériau conducteur configuré pour blinder l'élément de canal (201) vis-à-vis de champs électromagnétiques générés par des signaux électriques se déplaçant à travers des interconnexions électriques sur le substrat de support (202) pour faciliter la circulation de courant électrique à travers l'élément de canal (201).

6. Dispositif (210) selon l'une quelconque des revendications précédentes, dans lequel la nanomembrane (211) comprend un ou plusieurs dopants (714a,b) configurés pour provoquer une variation du courant électrique à travers l'élément de canal (201).

7. Dispositif (210) selon l'une quelconque des revendications précédentes, lequel dispositif (210) comprend une couche de matériau conducteur (312) entre la nanomembrane (211) et le substrat de support (202), et dans lequel la nanomembrane (211) comprend un matériau diélectrique configuré pour agir comme un écarteur diélectrique entre l'élément de canal (201) et la couche de matériau conducteur (312) de façon qu'une tension appliquée à la couche de matériau conducteur (312) puisse être utilisée pour faire varier le courant électrique à travers l'élément de canal (201).

8. Dispositif (210) selon l'une quelconque des revendications précédentes, lequel dispositif (210) comprend une troisième électrode (206) séparée de l'élément de canal (201) par une autre nanomembrane (207), l'autre nanomembrane (207) comprenant un matériau diélectrique configuré pour agir comme un écarteur diélectrique entre la troisième électrode (206) et l'élément de canal (201) de façon qu'une tension appliquée à la troisième électrode (206) puisse être utilisée pour faire varier le courant électrique à travers l'élément de canal (201).

9. Dispositif (210) selon l'une quelconque des revendications 1 à 6, lequel dispositif (210) comprend une autre nanomembrane (511') du côté de l'élément de canal (201) opposé au substrat de support (202), l'autre nanomembrane (511') comprenant une espèce réceptrice configurée pour se lier spécifiquement à une espèce chargée (513) provenant du milieu environnant, liant l'espèce réceptrice à l'espèce chargée (513) en positionnant l'espèce chargée (513) suffisamment à proximité de l'élément de canal (201) pour provoquer une variation du courant électrique à travers celui-ci.

10. Dispositif (210) selon l'une quelconque des revendications 1 à 8, lequel dispositif (210) comprend une autre nanomembrane (511') du côté de l'élément de canal (201) opposé au substrat de support (202), l'autre nanomembrane (511') comprenant un ou plusieurs pores configurés pour permettre à une espèce analytique spécifique (513) provenant du milieu environnant, de traverser pour interagir avec l'élément de canal (201), l'interaction de l'espèce analytique (513) avec l'élément de canal (201) provoquant une variation du courant électrique à travers l'élément de canal (201).

11. Dispositif (210) selon l'une quelconque des revendications 1 à 8, lequel dispositif (210) comprend une autre nanomembrane (811') du côté de l'élément de canal (201) opposé au substrat de support (202), l'autre nanomembrane (811') étant configurée pour protéger l'élément de canal (201) et les électrodes (203, 204) vis-à-vis du milieu environnant.

12. Dispositif (210) selon l'une quelconque des revendications précédentes, dans lequel au moins l'un parmi la nanomembrane (211), l'autre nanomembrane (207, 511', 811'), l'élément de canal (201), les électrodes (203, 204), la couche de matériau conducteur (312) et le substrat de support (202) sont configurés pour être ou plusieurs parmi déformables réversiblement, flexibles réversiblement, étirables réversiblement et compressibles réversiblement.

13. Procédé de production d'un dispositif (210), le procédé comprenant :
la formation (1521) d'une nanomembrane (211) comprenant une couche de nanomembrane de carbone électriquement isolante au-dessus d'un substrat de support (202) ;
la formation (1522) d'un élément de canal (201) au-dessus de la nanomembrane (211) ; et
la formation (1523) de première (203) et deuxième (204) électrodes configurées pour permettre une circulation de courant électrique de la première électrode (203) à la deuxième électrode (204) par l'intermédiaire de l'élément de canal (201),
dans lequel la nanomembrane (211) est configurée pour faciliter la circulation du courant électrique à travers l'élément de canal (201) en inhibant les fuites de courant électrique de l'élément de canal (201) au substrat de support (202) .

14. Programme informatique comprenant un code informatique configuré pour commander le procédé de la revendication 13.
